# EUROPEAN PATENT APPLICATION

(11) **EP 4 528 797 A1**
(43) Date of publication of application: **26.03.2025**
(21) Application number: 23198772.8
(22) Date of filing: 21.09.2023
(51) Int. Cl.: H01L 21/768, H01L 21/8234, H01L 23/528

(54) **METHOD FOR FORMING A SELF-ALIGNED BURIED POWER RAIL IN A NANOSHEET-BASED TRANSISTOR DEVICE**

(71) Applicant: Imec VZW, 3001 Leuven (BE)
(72) Inventor: CHAN, Boon Teik, 3012 Wilsele (BE); HIBLOT, Gaspard, deceased (BE); MIRABELLI, Gioele, 3000 Leuven (BE)
(74) Representative: AWA Sweden AB

(57) **Abstract**

A method (100) for forming a nanosheet-based transistor device is provided. The method (100) comprises forming (105) a shallow trench isolation, STI, structure (212) in a substrate (202), forming (110) a fin-shaped structure (214) from the substrate (202), a bottom sacrificial layer (204), and a stack of layers (208, 210), forming (115) a dummy gate stack (216) over a channel region of the fin-shaped structure (214), forming (120) a source/drain, S/D, recess (218) at a S/D region (218) of the fin-shaped structure (214), the S/D recess (218) extending through the stack of layers (208, 210) and the bottom sacrificial layer (204), removing (125) the bottom sacrificial layer (204) thereby forming a void space, depositing (130) a bottom dielectric insulation, BDI, layer (220) in the void space, extending (135) the S/D recess (218) further into the substrate (202), depositing (140) a via buried power rail, VBPR, plug (222) in the extended S/D recess (218), forming (145) an epitaxial, EPI, structure (224) to form a S/D feature (224) above the VBPR plug (222) in the S/D recess (218), removing (150) the dummy gate stack (216), selectively removing (155) the plurality of sacrificial layers (210) in the channel region, forming (160) a replacement metal gate, RMG, structure (226) around each of the plurality of released channel layers (208), thinning (165) the substrate (202) from a backside thereof, selectively etching (170) the VBPR plug (222) to expose the S/D feature (224), and forming a backside S/D electrical contact (238) at the S/D feature (224).

## Description

### TECHNICAL FIELD

The present disclosure belongs to methods for forming a self-aligned buried power rail in a nanosheet-based transistor device.

### BACKGROUND

The semiconductor industry has recently grown immensely with advancements in materials and design, leading to smaller and more complex circuits. The number of circuits per chip area has increased while geometry size has decreased, improving production efficiency, and reducing costs. The complexity of integrated circuit processing and manufacturing has also increased. Multi-gate devices like FinFETs and nanosheet-based transistors have been introduced to enhance gate control and reduce current leakage. Existing backside contact structures, although generally adequate, have limitations due to overlay variations during formation, which may result in device defects.

US 2021/0376093 A1 discusses a method for forming a backside power rail disposed over a bottom dielectric layer, and a backside source contact disposed between a source feature and the backside power rail, where the backside source contact extends through the bottom dielectric layer.

### SUMMARY

An object of the present inventive concept is to provide an improved method for forming a self-aligned buried power rail, BPR, in a nanosheet-based transistor device.

Another object is to provide a more reliable method for forming a self-aligned BPR in a nanosheet-based transistor device.

Another object is to provide a faster method for forming a self-aligned BPR in a nanosheet-based transistor device.

Another object is to provide a less costly approach for forming a self-aligned BPR in a nanosheet-based transistor device.

According to a first aspect, there is provided a method for forming a nanosheet-based transistor device from a preform comprising a substrate, a bottom sacrificial layer disposed over a frontside of the substrate, a stack of layers disposed over the bottom sacrificial layer, the stack comprising a plurality of channel layers alternately arranged by a plurality of sacrificial layers, the method comprising: forming a shallow trench isolation, STI, structure in the substrate; forming a fin-shaped structure from the substrate, the bottom sacrificial layer, and the stack of layers; forming a dummy gate stack over a channel region of the fin-shaped structure; forming a source/drain, S/D, recess at a S/D region of the fin-shaped structure, the S/D recess extending through the stack of layers and the bottom sacrificial layer; removing the bottom sacrificial layer thereby forming a void space; depositing a bottom dielectric insulation, BDI, layer in the void space, thereby filling the void space; extending the S/D recess further into the substrate; depositing a via buried power rail, VBPR, plug in the extended S/D recess; forming an epitaxial, EPI, structure to form a S/D feature above the VBPR plug in the S/D recess; removing the dummy gate stack; selectively removing the plurality of sacrificial layers in the channel region, thereby releasing the plurality of channel layers; forming a replacement metal gate, RMG, structure around each of the plurality of released channel layers- thinning the substrate from a backside thereof, thereby revealing the VBPR plug; selectively etching the VBPR plug to expose the S/D feature; and forming a backside S/D electrical contact at the S/D feature.

By having the BDI embedded while processing the transistor device from the frontside during the VBPR formation facilitates avoiding HK (high-k gate dielectric material) defects during the thinning or removal of the substrate from the backside thereof. Upon bonding and flipping the transistor device (more correctly, a wafer having thereon a large number of transistor devices) and thinning or removing the substrate from the backside thereof to expose the VBPR plug, the chemical processing will expose to the HK in the RMG. Hence, presence of the BDI according to the present approach may prevent plasmatic or chemical HK defects. The present approach may thereby provide for a more reliable and safe manufacturing method. Further, the present approach may save time upon manufacturing nanosheet-based transistor devices.

The method may in principle be applicable to any type of nanosheet-based transistor device, such as a finFET device, a CFET device, a forksheet device, or the like. Any of these transistor types generally functions according to having one or more channels in which electrons/holes may move upon applying a bias voltage over the channel region, i.e., between the source region and the drain region, controlled by a gate potential. The electron or hole flow is thus further tuned or turned on/off by changing an electric potential at a gate structure located between the source region and the drain region.

The region at which the gate structure is arranged may thus henceforth be referred to as "channel region" or "active region".

The "stack of layers" may refer to a stack comprising one or more layers, e.g., nanosheets.

According to the above, "the S/D region" may refer to either or both of the source region and the drain region of the nanosheet device.

"Wafer" herein (and elsewhere) refers to a relatively large, possibly at least partially processed, preform on which a relatively large number of nanosheet-based transistor devices have been or are to be formed. Such a wafer may have an area of a magnitude in the order of cm², e.g., 10-1000 cm².

"Substrate" refers throughout to a material forming a base for other materials/compounds/structures to be arranged thereon. Although etched away portions being possibly filled by another material (such as STI structures vertically extending into the substrate), these materials/features do not generally form part of the substrate as defined herein.

Preferably, the steps of removing the bottom sacrificial layer and of depositing the BDI layer are conducted prior to the step of extending the S/D recess.

This embodiment in particular may prevent plasmatic or chemical HK defects according to the above.

Alternatively, the step of removing the bottom sacrificial layer may be conducted subsequent to the step of extending the S/D recess, and the steps of depositing the BDI layer and of depositing the VBPR plug may be conducted concurrently while depositing a same material.

Also this embodiment may prevent plasmatic or chemical HK defects according to the above.

Preferably, the method further comprises, prior to extending the S/D recess: depositing a mask layer on the frontside of the substrate; forming an opening in the mask layer, the opening laterally coinciding with the S/D recess; and selectively etching a spin-on-carbon, SoC, layer present in the S/D region.

The step of thinning the substrate from the backside thereof may comprise completely removing the substrate.

This may render performing backside lithography unnecessary, hence facilitating saving manufacturing time, as well as providing a more flexible manufacturing approach.

The method may further comprise, subsequent to the step of thinning the substrate, depositing a mask layer at the backside of the substrate, forming an opening in the mask layer, the opening laterally coinciding with the revealed VBPR plug, and selectively etching the VBPR plug through the opening of the mask layer to expose the S/D feature from the backside of the substrate.

Preferably, either or both of the opening of the mask is larger than, and/or laterally displaced to, the S/D region.

Hence, it is not necessary to have a precise matching between the opening and the S/D region. This may save manufacturing time.

Preferably, the opening of the mask layer is larger than, and/or laterally displaced to, the VBPR plug.

The method may further comprise etching away portions, facing inwardly to the S/D region, of the sacrificial layers, and depositing, on the etched away portions, an inner spacer layer.

The inner spacer may block the sacrificial layers from being exposed from the EPI structure of the S/D feature, thereby preventing the EPI structure to grow beside it. This may occasionally be referred to as inner spacer etching, ISP.

The method may further comprise depositing a contact layer on the EPI structure.

The contact layer may be a contact etch stop layer, CESL.

The method may further comprise depositing a buried power rail, BPR, extending between adjacent stacks on the backside of the substrate, the BPR thereby electrically connecting the adjacent stacks.

Preferably, one or more of the following applies:
the substrate comprises Si;
the bottom sacrificial layer comprises SiₓGe₁₋ₓ, wherein x belongs to the range 0.5 ≤ x ≤ 0.7;
the channel layers comprise Si;
the sacrificial layers comprise Si_{y}Ge_{1-y}, wherein y belongs to the range 0.75 ≤ y ≤ 0.90;
the dummy gate stack comprises poly Si or amorphous Si, aSi;
the VBPR plug comprises one or more of SiN, SiCN, SiOCN, SiOC, SiOBCN and/or based on dual dielectric film materials such as a SiN liner and a SiO₂ filler;
the BDI layer comprises one or more of SiO₂, SiN, SiCN, SiOCN, SiOC, and SiOBCN;
the SoC layer comprises polymeric methylsilsesquioxane, MSQ, or hydrogen silsesquioxane, HSQ;
the mask comprises chemical amplified resist, CAR, or metal-organic resist, MOR; and
the EPI structure comprises SiN.

An upper vertical level of the STI structure may be at a vertical level of the BDI layer or above the vertical level of the BDI layer.

This facilitates reducing unnecessary exposure at the metal HK during backside substrate removal.

The method may further comprise depositing a second BDI layer on the BDI layer from the backside thereof subsequently to the complete removal of the substrate.

This may prevent loss of BDI from frontside during etch-back and thus increases the thickness of the dielectric materials to further isolate the metal in contact with the RMG.

Preferably, the EPI structure comprises a dopant comprising one or more of P, As, and B, and the VBPR plug is preferably free of the dopant.

Preferably, the EPI structure comprises SiGe with a B dopant for p-EPI structure, and Si with P dopant for n-EPI structure.

A further scope of applicability of the present inventive concept will become apparent from the detailed description given below. However, it should be understood that the detailed description and specific examples, while indicating preferred embodiments of the inventive concept, are given by way of illustration only, since various changes and modifications within the scope of the inventive concept will become apparent to those skilled in the art from this detailed description.

Hence, it is to be understood that the present inventive concept is not limited to the particular component parts of the device described or acts of the methods described as such device and method may vary. It is also to be understood that the terminology used herein is for the purpose of describing particular embodiments only and is not intended to be limiting. It must be noted that, as used in the specification and the appended claims, the articles "a," "an," "the," and "said" are intended to mean that there are one or more of the elements unless the context clearly dictates otherwise. Thus, for example, reference to "a unit" or "the unit" may include several units, and the like. Furthermore, the words "comprising", "including", "containing" and similar wordings do not exclude other elements or steps.

### BRIEF DESCRIPTION OF THE DRAWINGS

The above, as well as additional objects, features, and advantages of the present inventive concept, will be better understood through the following illustrative and non-limiting detailed description, with reference to the appended drawings, in the drawings like reference numerals will be used for like elements unless stated otherwise.
Fig. 1 shows a flowchart of a method for forming a nanosheet-based transistor device.
Figs 2-15 schematically show cross-sectional profiles of a nanosheet-based transistor device according to a first embodiment during mandatory or optional manufacturing steps.
Figs 16-29 schematically show cross-sectional profiles of a nanosheet-based transistor device according to a second embodiment during mandatory or optional manufacturing steps.
Fig 30 schematically shows a top view of the nanosheet-based transistor device and highlights locations of the cuts depicted for the cross-sectional profiles in Figs 2-29.

### DETAILED DESCRIPTION

The present inventive concept will now be described more fully hereinafter with reference to the accompanying drawings, in which currently preferred variants of the inventive concept are shown. This inventive concept may, however, be embodied in many different forms and should not be construed as limited to the embodiments set forth herein; rather, these embodiments are provided for thoroughness and completeness, and to fully convey the scope of the inventive concept to the skilled person.

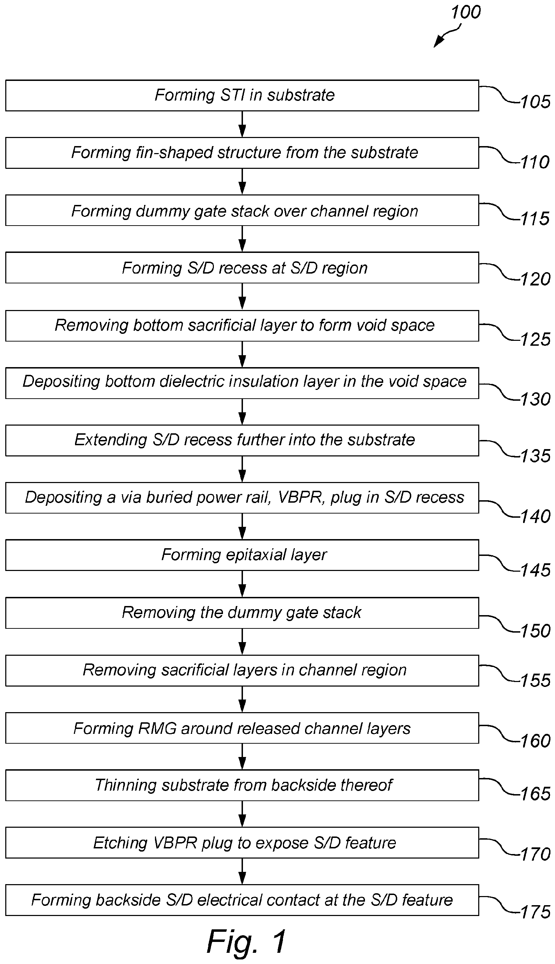

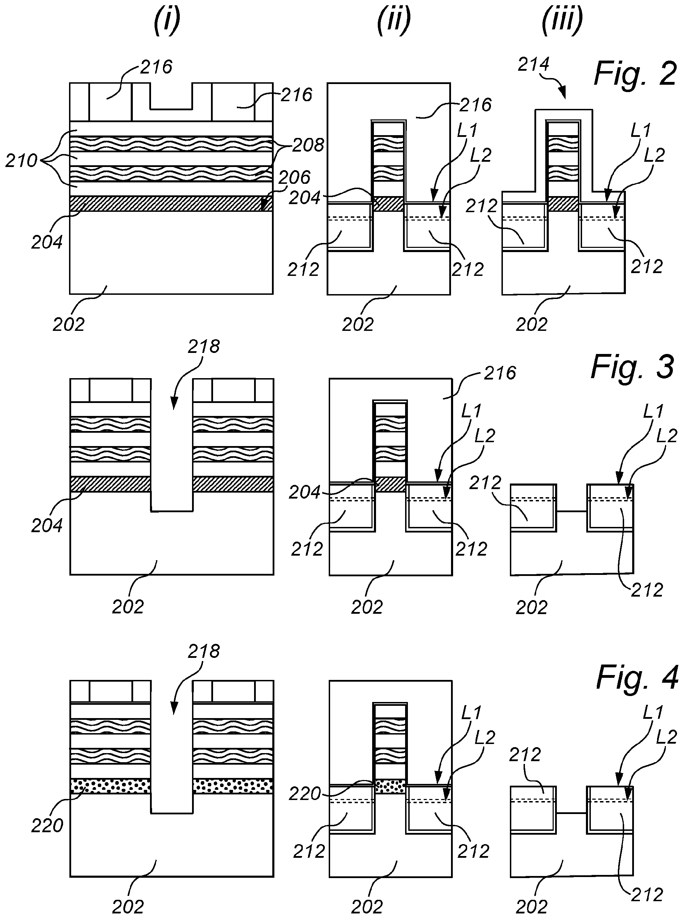

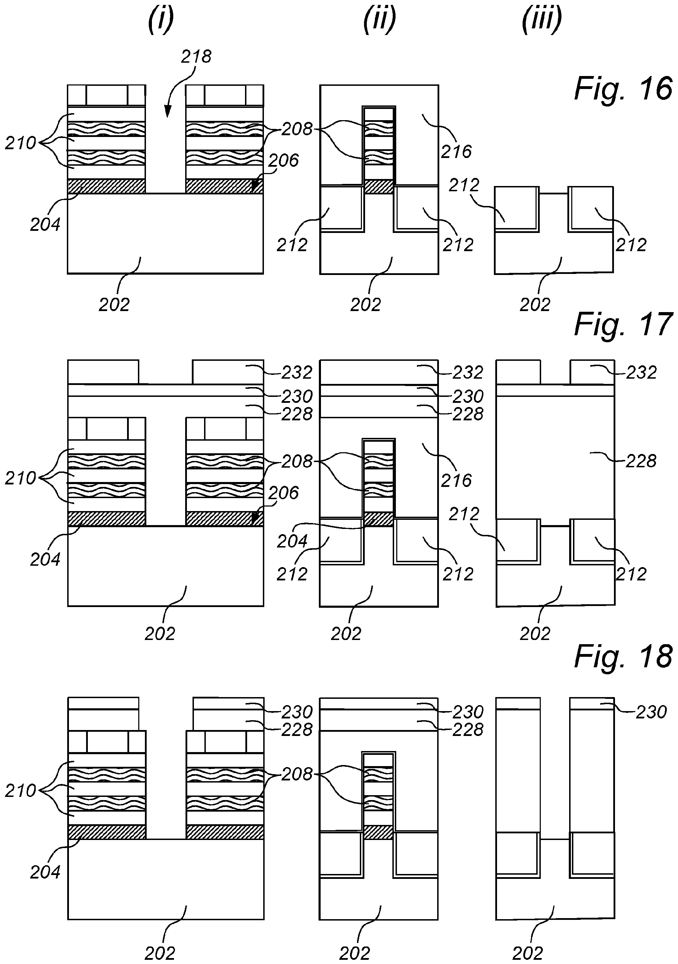

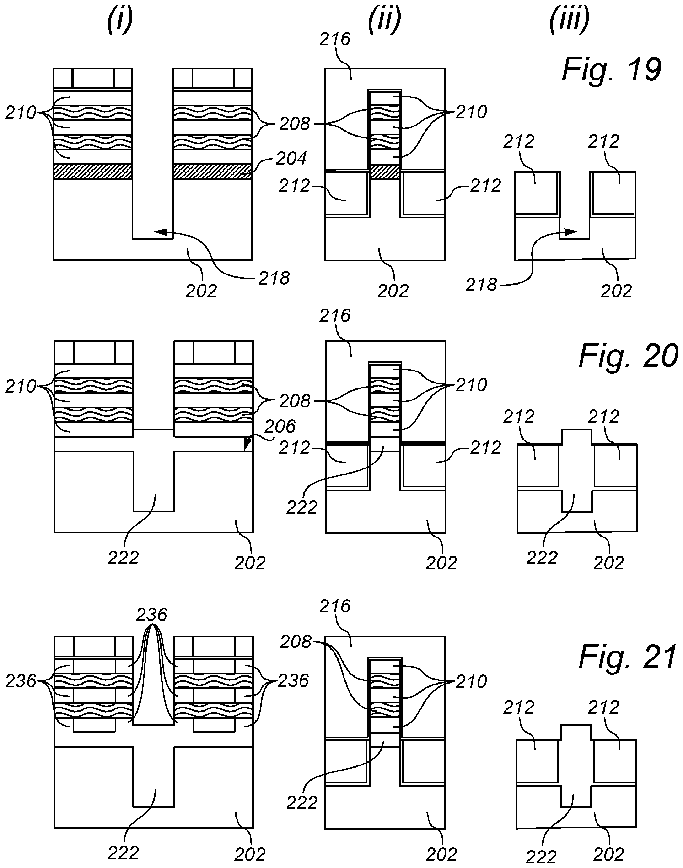

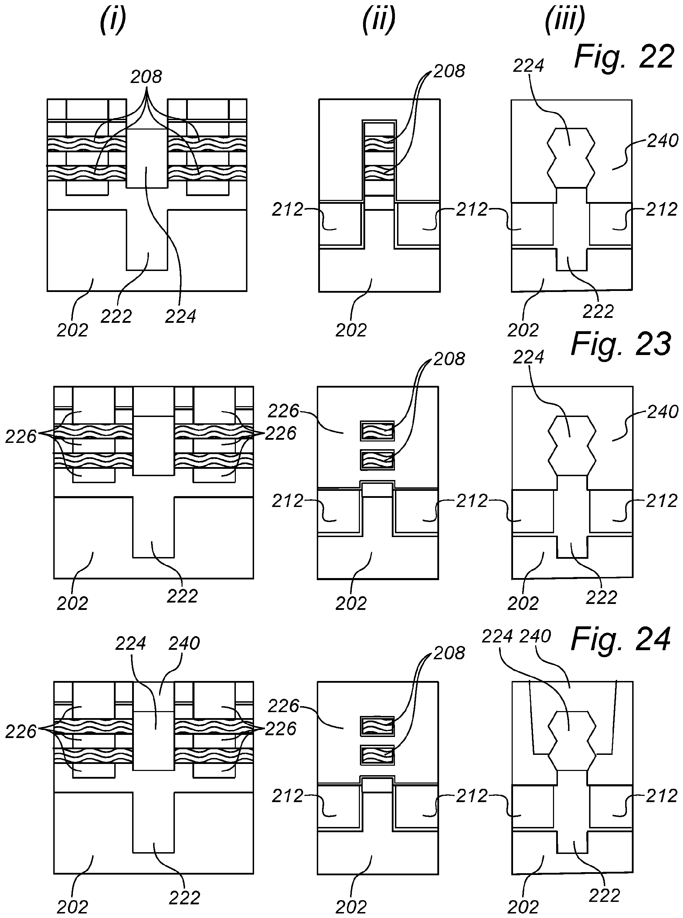

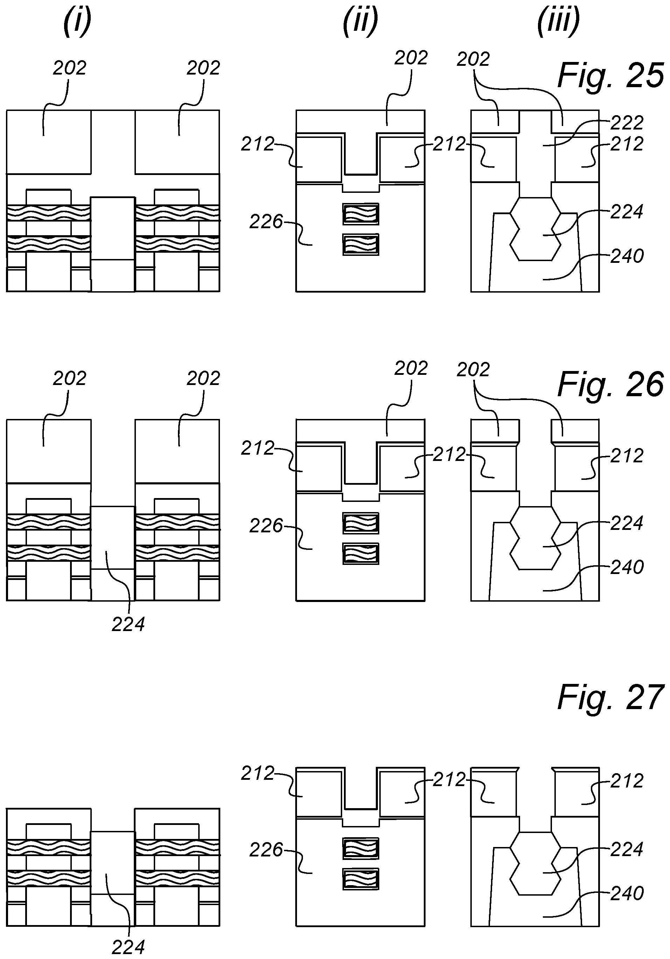

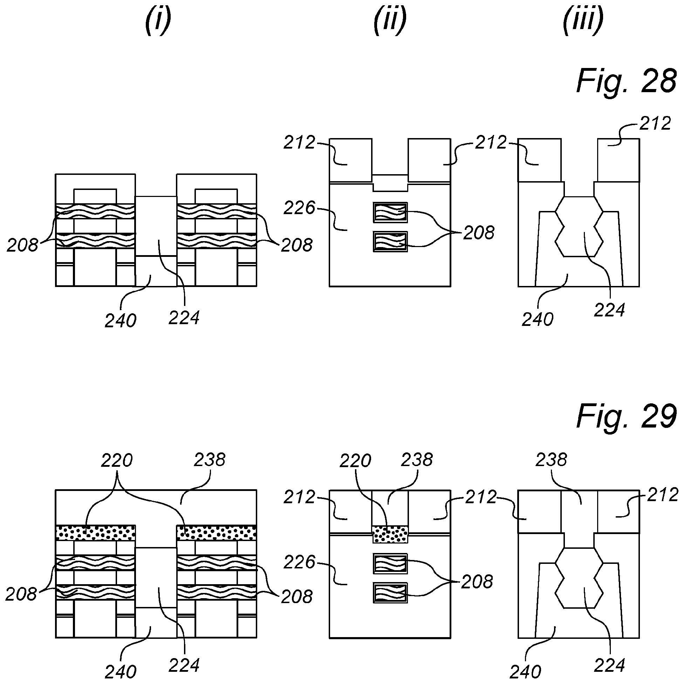

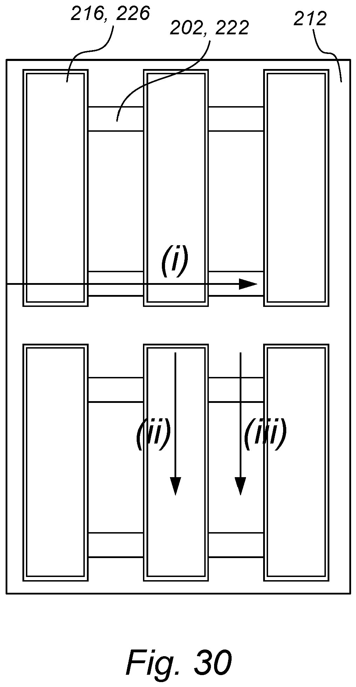

The below description of example embodiments is organized as follows. Fig. 1 depicts a flowchart of a method 100 for forming a nanosheet-based transistor device. Figs 2-15 thoroughly depict the nanosheet-based transistor device as seen during mandatory or optional steps undergone to manufacture the nanosheet-based transistor device according to a first embodiment the method 100. Figs 16-29 thoroughly depict the nanosheet-based transistor device as seen during mandatory or optional steps undergone to manufacture the nanosheet-based transistor device according to a second embodiment of the method 100. Some drawings in connection with the second embodiment (Figs 16-29) are similar or identical to corresponding drawings for the first embodiment (Figs 2-15). This should not confuse the skilled person upon practicing the inventive concept; rather the apparent repetition of drawings facilitates understanding the inventive concept in a clear manner. To avoid unnecessary cluttering in the drawings, only presently relevant reference numerals are included therein. Further, in FFigs 2-29, there are shown cross-sectional profiles taken along different cuts of a preform possibly being at least in part processed according to the below described method 100. That is, the leftmost vertical columns (i) in Figs 2-29 all correspond to a cross-sectional profile considered at a specific cut, the middle column (ii) corresponds to a cross-sectional profile considered at another cut, etc. Fig. 30 schematically shows a top view including arrows (i), (ii) and (iii) along which the cross-sectional profiles in Figs 2-29 are considered. Although the top view depicted in Fig. 30 at a present manufacturing step is, e.g., completely covered by a temporal layer covering, the skilled person is expected to clearly appreciate the meaning of it.

Preferable options regarding temporal or final materials/compounds for manufacturing the nanosheet-based transistor device are substantially set forth in the end of the description, although some example materials are mentioned elsewhere.

The skilled person is further expected to appreciate that the substantially right angles depicted throughout in Figs 2-30 are highly schematic from a manufacturing point of view. In real nanosheet-based transistor device manufacturing processes, these angles are in general smooth/rounded, and difficult to control exactly.

The method 100 starts in a conventional manner. That is, a formation of the nanosheet-based transistor device starts from a preform comprising a substrate 202, a bottom sacrificial layer 204 disposed over a frontside 206 of the substrate 202, and a stack of layers 208, 210 disposed over the bottom sacrificial layer 204, wherein the stack 208, 210 comprises a plurality of channel layers 208 alternately arranged by a plurality of sacrificial layers 210. The number of layers in the stack of layers 208, 210 is preferably four or more, i.e., at least two channel layers 208 and at least two sacrificial layers 210. Preferably, a bottom layer and a top layer of the stack of layers 208, 210 comprises a sacrificial layer 210 regardless of the number of layers present therebetween. In particular, in events of Si/SiGe constituting a pair of one channel layer (Si) and one sacrificial layer (SiGe), the stack of layers 208, 210 may comprise up to seven such pairs. In practice, an optimal performance may be achieved while having two or three such pairs.

The method 100 comprises forming 105 a shallow trench isolation, STI, structure 212 in the substrate 202. The STI structure 212 may be formed/deposited by means of a conventional STI procedure. The STI structure 212 may prevent leakage of electric current between adjacent components on the substrate 202.

The method 100 further comprises forming 110 a fin-shaped structure 214 from the substrate 202, the bottom sacrificial layer 204, and the stack of layers 208, 210.

The method 100 further comprises forming 115 a dummy gate stack 216 over a channel region of the fin-shaped structure 214. The dummy gate stack 216 may be viewed as a fixture allowing the overall structure to be exposed to intermediate processes, to be subsequently removed and/or replaced by a functional gate structure; Fig. 2.

The method 100 further comprises forming 120 a source/drain, S/D, recess 218 at a S/D region of the fin-shaped structure 214, the S/D recess 218 extending through the stack of layers and the bottom sacrificial layer 204; Fig. 3. The S/D recess 218 may to a certain extent extend vertically into the substrate 202. The certain extent may be of the order of a vertical thickness of the sacrificial layer 204.

An upper vertical level L1 of the STI structure 212 may be at a vertical level of the bottom sacrificial layer 204 or above the vertical level L2 of the bottom sacrificial layer 204. This is schematically shown in Figs 2-4 and may apply throughout the disclosure. Although not shown in the exemplary drawings thereafter, this may further be the case below, where the bottom sacrificial layer 204 has been replaced by a bottom dielectric insulation, BDI, layer, 220 since the space occupied by the BDI layer 220 substantially coincides with the space occupied by the removed bottom sacrificial layer 204. Hence, explicitly, the upper vertical level L1 of the STI structure 212 may be at a vertical level L1 of the BDI layer 220 or above the vertical level L2 of the BDI layer 220. This is shown in Fig. 4 but is applicable in the subsequent drawings.

The method 100 further comprises removing 125 the bottom sacrificial layer 204 thereby forming a void space. This is made at an intermediate step occurring between Fig. 3 and Fig. 4

The method 100 further comprises depositing 130 a bottom dielectric insulation, BDI, layer 220 in the void space, thereby filling the void space; Fig. 4.

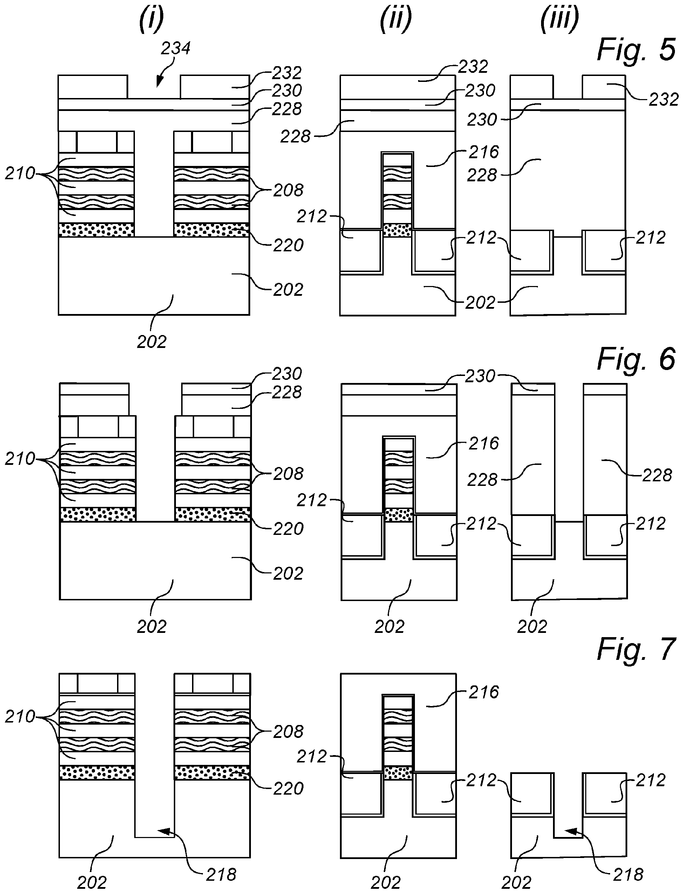

The method 100 further comprises extending 135 the S/D recess further into the substrate; Fig. 7. This may be done by selectively etching the S/D recess 218 further (vertically) into the substrate 202 with respect to the STI structure 212. The space 218 generated by the extension 135 of the S/D recess 218 may be referred to as the extended S/D recess 218 henceforth.

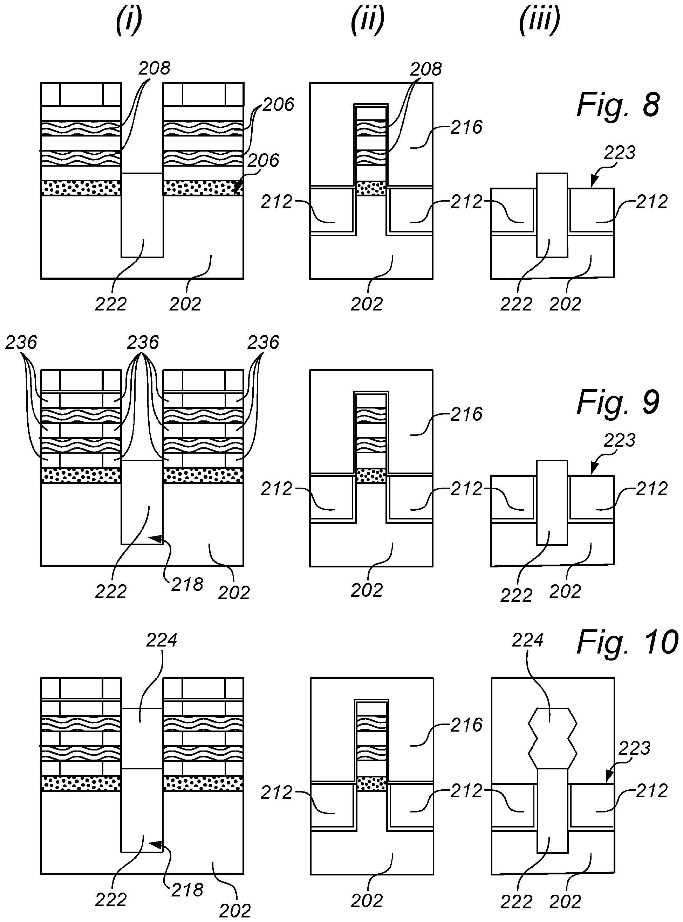

The method 100 further comprises depositing 140 a via buried power rail, VBPR, plug 222 in the extended S/D recess 218; Fig. 8. The VBPR plug 222 may, after depositing it, extend above a top surface 206 of the substrate 202. The VBPR plug 222 may also, after depositing it, extend vertically above a top surface 223 of the STI structure 212. Further, the top surface 223 of the STI structure 212 may vertically protrude relative the top surface 206 of the substrate 202.

The method 100 further comprises forming 145 an epitaxial, EPI, structure 224 to form a S/D feature 224 above the VBPR plug 222 in the S/D recess 218; Fig. 10. The EPI structure 224 may preferably be in direct contact with the VBPR plug 222; however, indirect contact may be possible by means of a suitable intermediate layer. The schematically depicted diamond/rhombic geometry of the epi structure 224 may originate from crystalline growth of these materials at the S/D region and may thus depend on the Miller indices (e.g., 110, 111, etc.) of these materials relative to the surface they are grown on. The depiction of the geometry of the EPI structure 224 is however here schematic.

The method 100 further comprises removing 150 the dummy gate stack 216.

The method 100 further comprises selectively removing 155 the plurality of sacrificial layers 210 in the channel region, thereby releasing the plurality of channel layers 208.

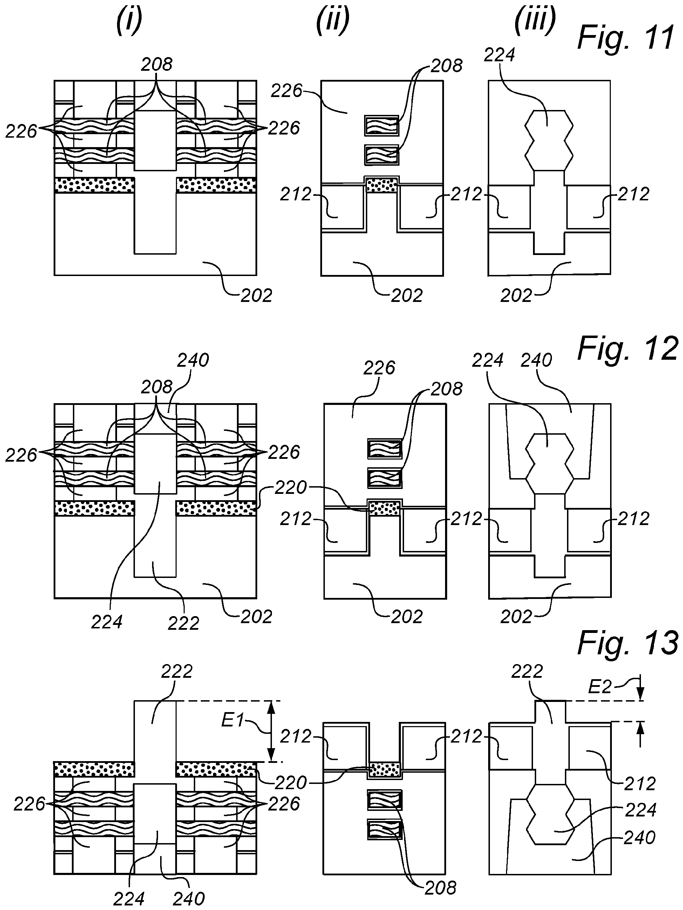

The method 100 further comprises forming 160 a replacement metal gate, RMG, structure 226 around each of the plurality of released channel layers 208; Fig. 11.

The method 100 further comprises thinning 165 the substrate from a backside thereof, thereby revealing the VBPR plug 222; Fig. 13.

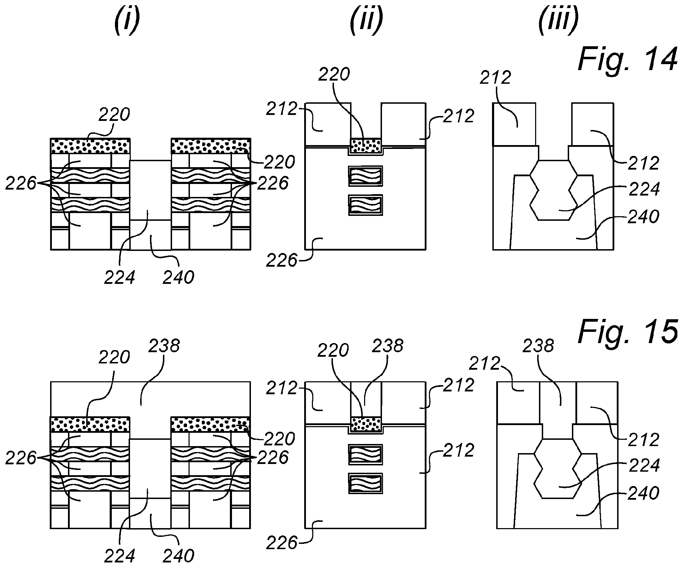

The method 100 further comprises selectively etching 170 the VBPR plug 222 to expose the S/D feature 224; Fig. 14.

The method 100 further comprises forming 175 a backside S/D electrical contact 238 at the S/D feature 224; Fig. 15. As appreciated, the cross-sectional profiles of Figs 13-15 are depicted upside-down compared to Figs 2-12.

The steps of removing 125 the bottom sacrificial layer 204 and the step of depositing 130 the BDI layer 220 may be conducted prior to the step of extending 135 the S/D recess 218. This particular ordering of the method steps refers to the first embodiment throughout and thus refers to (some of the) Figs 2-15.

Alternatively, the step of removing 125 the bottom sacrificial layer 204 may be conducted subsequent to the step of extending 135 the S/D recess 218, and the steps of depositing 130 the BDI layer 220 and depositing 140 the VBPR plug 222 may be conducted concurrently while depositing a same material. This alternative procedure refers to the second embodiment throughout and thus refers to (some of the) Figs 16-29.

According to the first embodiment, the method 100 may further comprise, prior to extending 135 the S/D recess, depositing a spin-on carbon, SoC, layer 228 over the nanosheet-based transistor device, depositing a hardmask layer 230 above the SoC layer 228, depositing a photomask layer 232 above the hardmask layer 230, etching an opening 234 on the photo mask, the opening laterally coinciding with the S/D recess 218, etching an opening 234 on the SoC layer 228, the opening 234 laterally coinciding with the opening 218 on the photo mask layer 232, and etching away the SoC layer 228 present in the S/D region 218.

Either or both of the opening of the photomask mask layer and the hardmask layer may be larger than, and/or laterally displaced to, the S/D region 218. This is partly schematically depicted in Fig. 6, where both a width of the photomask layer 232 and a width of the hardmask layer 230 are larger than a width of the S/D recess 218 when viewed in the plane of the depicted cross-sectional profile (i.e., column (i)). Widths of the above-mentioned openings may as appreciated vary along different directions in many ways and are thus in practice difficult, and, to a certain extent unnecessary, to control exactly.

On a more general level, the steps in connection hereto (first embodiment) are depositing a mask layer on a frontside of the substrate 202, forming an opening in the mask layer, the opening laterally substantially coinciding with the S/D recess, and selectively etching the SoC layer present in the S/D region 218. Etching in connection hereto may be isotropic (hence, implying wet etch), but can alternatively or additionally be gaseous.

Further, in accordance with the first embodiment, the step of thinning 165 the substrate 202 from the backside thereof may comprise completely removing the substrate; Fig. 13. Thereafter, the VBPR plug 222 may, at the backside, protrude from the bottom dielectric layer 220 to a first extent E1, and may, consequently, protrude from the STI structure 212 to a second extent E2 being smaller than the first extent E1. The STI structure 212 is thus understood not being removed at this step. For reference, the substrate, normally made of Si, may have a vertical thickness of 200-800 µm (typically a 300 µm Si wafer), whereas the components/layers discussed throughout herein typically have a thickness of around 50-200 nm.

The VBPR plug 222 deposition/formation may however be done in several ways. In connection with the first embodiment lithography may be performed from the frontside prior to the VBPR plug 222 formation. Afterwards a backside lithography may be performed to expose the VBPR plug 222 at the backside for power routing, etc. Alternatively, in connection with the second embodiment, formation of the VBPR plug 222 at the S/D region 218 may be done without frontside lithography. Thereafter, a backside lithography may be performed to expose the VBPR plug 222 at the backside, i.e., from the below. This is further elaborated on below.

Another option concerns lithography from the frontside prior to the VBPR plug 222 formation. Afterwards, backside lithography may turn unnecessary, and may hence be omitted. Instead, exposing the VBPR plug 222 from the backside may comprise recessing the substrate completely until the VBPR plug 222 protrudes from the backside.

Hence, the VBPR plug 222 material may be the same material (e.g. SiN) or the same dual material (e.g. SiN liner and SiO₂ fill) as the BDI layer 220 material.

Lithography may hence be performed differently for the second embodiment. For example, the method 100 may in connection hereto further comprise, subsequent to the step of thinning 165 the substrate 202, depositing a mask layer at the backside of the substrate, forming an opening in the mask layer, the opening laterally coinciding with the revealed VBPR plug 222, and selectively etching the VBPR plug 222 through the opening of the mask layer to expose the S/D feature 218 from the backside of the substrate. Masking may be done with any adequate technique. For instance, multilayer patterning stacking may be possible in events of obtaining a smaller critical dimension, CD, with a straight profile. Hence, a system with a photomask in combination with a hardmask or release layer may be possible.

The opening of the mask layer may be larger than, and/or laterally displaced to, the VBPR plug 222 also for the second embodiment.

The method 100 may further comprise etching away portions, facing inwardly to the S/D region, of the sacrificial layers 210, and depositing, on the etched away portions, an inner spacer layer 236; Fig. 9. The inner spacer layer 236 may be a single layer or dual layers. Example manufacturing materials for the inner spacer are SiOCN, SIO₂/SiOCN, SiOC/SiOCN, SiOC, SiN, and SiCN.

The method 100 may further comprise depositing a contact layer 240 on the EPI structure 224.

The method 100 may further comprise depositing a buried power rail, BPR, extending between adjacent stacks on the backside of the substrate, the BPR thereby electrically connecting the adjacent stacks. This feature is not depicted among the appended drawings but is expected to be readily appreciated by the skilled person upon practicing the inventive concept.

Below follows example materials for some of the above-mentioned components.

The substrate 202 may comprise Si.

The bottom sacrificial layers 204 may comprise SiₓGe₁₋ₓ, wherein x belongs to the range 0.5 ≤ x ≤ 0.7.

The channel layers 208 may comprise Si.

The sacrificial layers 210 may comprise Si_{y}Ge_{1-y}, wherein y belongs to the range 0.75 ≤ y ≤ 0.90.

The dummy gate stack 216 may comprise poly Si.

The VBPR 222 plug may comprise one or more of SiN, SiCN, SiOCN, SiOC, and SiOBCN. The VBPR plug 222 may be formed from dual dielectric film materials by, e.g., a SiN liner and a SiO₂ filler.

The BDI layer 220 may comprise one or more of SiO2, SiN, SiCN, SiOCN, SiOC, and SiOBCN.

The SoC layer may comprise polymeric methylsilsesquioxane, MSQ, or hydrogen silsesquioxane, HSQ.

The mask may comprise chemical amplified resist, CAR, or metal-organic resist, MOR. The MOR may be Si based.

The EPI structure may comprise SiN. The EPI structure may comprise a dopant comprising one or more of P, As, and B. The VBPR plug may be free of the dopant.

Accordingly, and in summary, in some variants discussed above, there has been described a method for forming a nanosheet-based transistor device with emphasis on power routing by means of a via buried power rail plug 222.

The person skilled in the art realizes that the present inventive concept by no means is limited to the preferred embodiments described above. On the contrary, many modifications and variations are possible within the scope of the appended claims. Variations to the disclosed embodiments can be understood and effected by the skilled person upon practicing the claimed inventive concept, from a study of the drawings, the disclosure, and the appended claims.

## Claims

1. A method (100) for forming a nanosheet-based transistor device from a preform comprising a substrate (202), a bottom sacrificial layer (204) disposed over a frontside of the substrate (202), a stack of layers (208, 210) disposed over the bottom sacrificial layer (204), the stack (208, 210) comprising a plurality of channel layers (208) alternately arranged by a plurality of sacrificial layers (210), the method (100) comprising:
forming (105) a shallow trench isolation, STI, structure (212) in the substrate (202);
forming (110) a fin-shaped structure (214) from the substrate (202), the bottom sacrificial layer (204), and the stack of layers;
forming (115) a dummy gate stack (216) over a channel region of the fin-shaped structure (214);
forming (120) a source/drain, S/D, recess (218) at a S/D region of the fin-shaped structure (214), the S/D recess (218) extending through the stack of layers (208, 210) and the bottom sacrificial layer (204);
removing (125) the bottom sacrificial layer (204) thereby forming a void space;
depositing (130) a bottom dielectric insulation, BDI, layer (220) in the void space, thereby filling the void space;
extending (135) the S/D recess (218) further into the substrate (202);
depositing (140) a via buried power rail, VBPR, plug (222) in the extended S/D recess (218);
forming (145) an epitaxial, EPI, structure (224) to form a S/D feature above the VBPR plug (222) in the S/D recess (218);
removing (150) the dummy gate stack (216);
selectively removing (155) the plurality of sacrificial layers (210) in the channel region, thereby releasing the plurality of channel layers (208);
forming (160) a replacement metal gate, RMG, structure (226) around each of the plurality of released channel layers (208);
thinning (165) the substrate (202) from a backside thereof, thereby revealing the VBPR plug (222);
selectively etching (170) the VBPR plug (222) to expose the S/D feature (224); and
forming (175) a backside S/D electrical contact (238) at the S/D feature (224).

2. The method (100) according to claim 1, wherein the steps of removing (125) the bottom sacrificial layer (204) and of depositing (130) the BDI layer (220) are conducted prior to the step of extending (135) the S/D recess (218).

3. The method (100) according to claim 1, wherein the step of removing (125) the bottom sacrificial layer (204) is conducted subsequent to the step of extending (135) the S/D recess (218), and wherein the steps of depositing (130) the BDI layer (220) and of depositing (140) the VBPR plug (222) are conducted concurrently while depositing a same material.

4. The method (100) according to claim 2, further comprising, prior to extending (135) the S/D recess (218):
depositing a mask layer on the frontside of the substrate (202);
forming an opening in the mask layer, the opening laterally coinciding with the S/D recess; and
selectively etching a spin-on-carbon, SoC, layer (228) present in the S/D region (218).

5. The method (100) according to any one of claims 1, 2 or 4, wherein the step of thinning (165) the substrate (202) from the backside thereof comprises completely removing the substrate (202).

6. The method (100) according to claim 3, further comprising, subsequent to the step of thinning (165) the substrate (202):
depositing a mask layer at the backside of the substrate (202);
forming an opening in the mask layer, the opening laterally coinciding with the revealed VBPR plug (222); and
selectively etching the VBPR plug (222) through the opening of the mask layer to expose the S/D feature (224) from the backside of the substrate (202).

7. The method (100) according to claim 4, wherein either or both of the opening of the mask is larger than, and/or laterally displaced to, the S/D region (218).

8. The method (100) according to claim 6, wherein the opening of the mask layer is larger than, and/or laterally displaced to, the VBPR plug (222).

9. The method (100) according to any one of claims 1-8, further comprising;
etching away portions, facing inwardly to the S/D region (218), of the sacrificial layers (210); and
depositing, on the etched away portions, an inner spacer layer (236).

10. The method (100) according to any one of claims 1-9, further comprising:
depositing a contact layer on the EPI structure (224).

11. The method (100) according to any one of claims 1-10, further comprising
depositing a buried power rail, BPR, (238) extending between adjacent stacks on the backside of the substrate (202), the BPR (238) thereby electrically connecting the adjacent stacks.

12. The method (100) according to any one of claims 1-11, wherein an upper vertical level (L1) of the STI structure (212) is at a vertical level (L2) of the BDI layer (220) or above the vertical level (L2) of the BDI layer (220).

13. The method (100) according to claim 5, further comprising depositing a second BDI layer on the BDI layer (220) from the backside thereof subsequently to the complete removal of the substrate (202).

14. The method (100) according to any one of claims 1-13, wherein one or more of the following applies:
the substrate (202) comprises Si;
the bottom sacrificial layer (204) comprises SiₓGe₁₋ₓ, wherein x belongs to the range 0.5 ≤ x ≤ 0.7;
the channel layers (208) comprise Si;
the sacrificial layers (210) comprise Si_{y}Ge_{1-y}, wherein y belongs to the range 0.75 ≤ y ≤ 0.90;
the dummy gate stack (216) comprises poly Si or amorphous Si, aSi;
the VBPR plug (222) comprises one or more of SiN, SiCN, SiOCN, SiOC, and SiOBCN;
the BDI layer (220) comprises one or more of SiO2, SiN, SiCN, SiOCN, SiOC, and SiOBCN;
the SoC layer (228) comprises polymeric methylsilsesquioxane, MSQ, or hydrogen silsesquioxane, HSQ;
the mask layer (232) comprises chemical amplified resist, CAR, or metal-organic resist, MOR.
the EPI structure (224) comprises SiN.

15. The method according to any one of claims 1-12, wherein the EPI structure (224) comprises a dopant comprising one or more of P, As, and B, and wherein the VBPR plug (222) is free of the dopant.
